# EUROPÄISCHE PATENTSCHRIFT

(11) **EP 1 314 988 B1**
(45) Veröffentlichungstag und Bekanntmachung des Hinweises auf die Patenterteilung: **15.04.2009**
(21) Anmeldenummer: 02023838.2
(22) Anmeldetag: 24.10.2002
(51) Int. Cl.: G01R 31/27

(54) **Verfahren zur Bestimmung von Widerstands- und/oder Kapazitätswerten**
Method for determining resistance and/or capacity values
Procédé pour la détermination de valeurs de résistance et/ou de capacité

(30) Priorität: 23.11.2001 DE 10157529
(43) Veröffentlichungstag der Anmeldung: 28.05.2003
(73) Patentinhaber: Insta Elektro GmbH, 58511 Lüdenscheid (DE)
(72) Erfinder: Mundinger, Harald, Dipl.-Ing., 58553 Halver (DE)

(56) Entgegenhaltungen:
- JP-A- 59 148 883
- US-B1- 6 420 880

## Beschreibung

Die vorliegende Erfindung geht von einem gemäß dem Oberbegriff des Hauptanspruches ausgeführten Verfahren aus.

Derartige Verfahren sind in der Regel dafür vorgesehen, veränderliche Werte wie z. B. Widerstandswerte von Widerständen, Kapazitätswerte von Kondensatoren usw. zu bestimmen bzw. zu erfassen. Ein solches Verfahren wird zum Beispiel dann notwendig, wenn mittels Sensoren Helligkeitswerte, Temperaturwerte usw. oder aber die Schleiferposition eines Potentiometers erfasst bzw. bestimmt werden sollen.

Ein dem Oberbegriff des Hauptanspruches entsprechendes Verfahren ist durch die JP 59-14 8883 A bekannt geworden. Bei diesem Verfahren zur Bestimmung von Widerstands- und/oder Kapazitätswerten mittels eines auf einem Chip vorhandenen Mikrocontroller mit zugeordnetem Oszillator wird zunächst eine mindestens einmalige Referenzmessung vorgenommen, bei der eine Referenzkapazität über einen Referenzwiderstand auf einen definierten Spannungspegel geladen bzw. entladen wird. Die dazu benötigte Zeit wird durch Zählen der Oszillatorperioden bestimmt, was zu Parameterschwankungen und zur Temperaturdrift führen kann. Ohne zusätzliche rechnerische Maßnahmen mit entsprechendem Energieverbrauch sind so die Werte nur vergleichsweise ungenau zu bestimmen.

Des weiteren ist in der Druckschrift Mikrochip, "Embedded Control Handbook", Nov. 1993, AN 512, Seiten 2-85 und 2-86 und in der Druckschrift Texas Instruments "MSP430 Family Architectural Guide and Module Library" aus dem Jahr 2000, Seite 1-9 ein Verfahren zur Bestimmung von Widerstandswerten angegeben. Solche, in der Praxis vielfach benutzte Verfahren zur Widerstandsbestimmung laufen im wesentlichen so ab, dass über den zu messenden Widerstand R_{MESS} eine Kapazität C_{REF} bis zum Erreichen eines definierten Spannungspegels aufzuladen oder zu entladen ist. Die dafür benötigte Zeit wird als Vielfaches N_{MESS} der zur Bestimmung benutzten Oszillatorperiode herangezogen. Exemplarstreuung der Kapazitätswerte von C_{REF}, Drifterscheinungen z. B. der Pegel der Ein- bzw. Ausgänge des Mikrocontrollers, Temperaturveränderungen und Alterung können jedoch dazu führen, dass es zu Verfälschungen der Messergebnisse kommt.
Außerdem wird bei einem solchen Verfahren zunächst mit einem präzisen Referenzwiderstand R_{REF} bekannter Größe, eine Referenzmessung durchgeführt um über den Quotienten von N_{MESS}/N_{REF} den tatsächlichen, aktuell vorliegenden Widerstandswert zu berechnen, dies bedeutet, R_{MESS} = R_{REF} x N_{MESS} / N_{REF} ist über eine Rechenoperation zu bestimmen. Die bei diesem Verfahren notwendige Divisionsrechenoperation benötigt nicht nur Programmspeicher sondern auch Rechenzeit, welche Ursache für einen erhöhten Stromverbrauch ist. Insbesondere die Anwendung eines solchen Verfahrens bei batteriebetriebenen Geräten ist dadurch nicht immer akzeptabel.

Ausgehend von einem solchermaßen ausgeführten Verfahren liegt der vorliegenden Erfindung die Aufgabe zugrunde, ein Verfahren bereitzustellen, bei dem zur exakten Bestimmung der zu messenden Widerstands- und/oder Kapazitätswerte Divisionsrechenoperationen nicht notwendig sind und somit der Stromverbrauch weitestgehend minimiert ist.

Erfindungsgemäß wird diese Aufgabe durch die im kennzeichnenden Teil des Hauptanspruches angegebenen Verfahrensschritte bzw. Maßnahmen gelöst.

Besonders vorteilhaft bei einem derartig ausgeführten Verfahren ist, dass Verfälschungen der Messergebnisse hervorgerufen z. B. durch Drifterscheinungen, Temperaturveränderungen, Alterung usw. weitestgehend ausgeschlossen sind und gleichzeitig lediglich besonders wenig Speicherplatz benötigt wird.

Weitere vorteilhafte Verfahrensschritte bzw. Maßnahmen eines solchen Verfahrens sind in den abhängigen Ansprüchen angegeben, anhand eines Ausführungsbeispieles sei die Erfindung näher erläutert. Dabei zeigen:

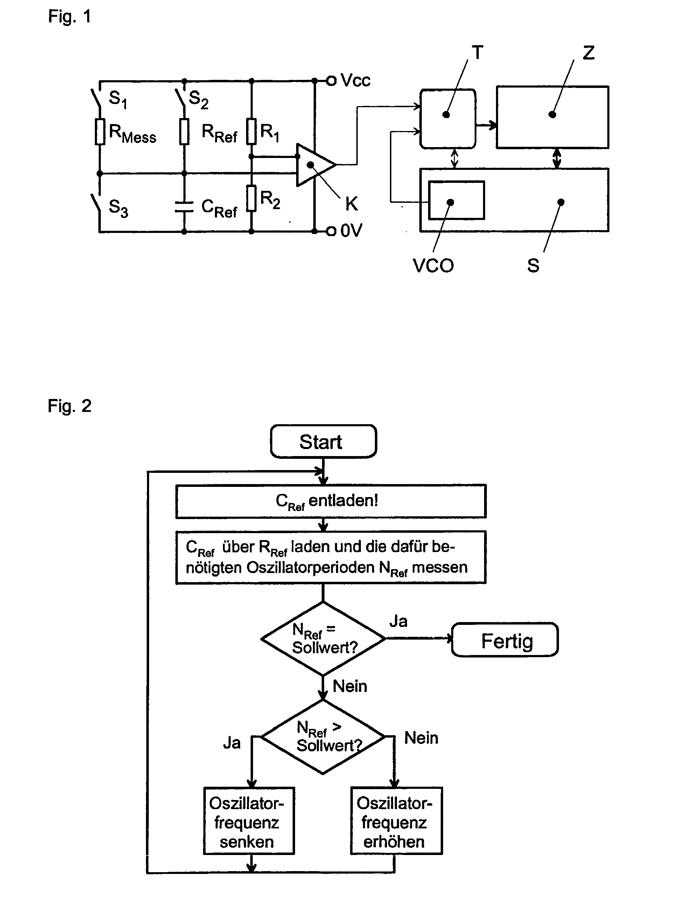

- Fig. 1: ein Prinzipschaltbild eines erfindungsgemäßen Verfahrens;
- Fig. 2: ein Ablaufdiagramm bezüglich der Einstellung der Oszillatorfrequenz bei einem erfindungsgemäßen Verfahren.

Wie insbesondere aus den beiden Figuren hervorgeht, wird durch zumindest einmalige Referenzmessung die zur Zeitmessung benutzte Frequenz des Oszillators VCO solange verändert, bis der bei der Referenzmessung ermittelte Messwert N_{MESS} einen vorbestimmten im Mikrocontroller gespeicherten Sollwert N_{REF} erreicht hat. Der, der Einfachheit halber nicht dargestellte, Mikrocontroller ist Bestandteil einer zugehörigen Steuerlogik S. Anschließend wird die sich aus der Referenzmessung ergebende Frequenz des Oszillators VCO für die Bestimmung eines aktuell vorliegenden Widerstandswertes R_{MESS} vom Mikrocontroller herangezogen. Die zur Zeitmessung benutzte Oszillatorperiode T_{MESS} des in dem Mikrocontroller realisierten steuerbaren Oszillators VCO wird dabei digital eingestellt, ist also variabel. Denkbar ist in diesem Fall jedoch auch die Anwendung eines spannungsgesteuerten Oszillators VCO zur Erzeugung einer variabel einstellbarer Frequenz. Nach dem Entladen bzw. Laden der Kapazität C_{REF,} wird diese über zumindest eine Referenzmessung mittels des Widerstandes R_{REF} wieder geladen bzw. entladen und die dafür benötigten Oszillatorperioden T_{MESS} mittels eines Komparators K, der über eine Torschaltung T und einen Zähler Z an die Steuerlogik S angebunden ist, gemessen. Bei einem anschließenden Vergleich wird festgestellt, ob die Anzahl der gemessenen Oszillatorperioden N_{MESS} dem im Mikrocontroller abgelegten Sollwert N_{REF} entspricht. Ist dies der Fall, bleibt die variabel einstellbare Frequenz des Oszillators VCO unverändert. Ist dies nicht der Fall, wird gegebenenfalls mehrmals die variabel einstellbare Frequenz des Oszillators VCO digital gesenkt oder erhöht, bis N_{MESS} dem im Mikrocontroller abgelegten Sollwert N_{REF} entspricht. Die variable Einstellung der Frequenz des Oszillators VCO erfolgt über die Torschaltung T und den Zähler Z, welche an die Steuerlogik S angebunden sind. Die selbe Anordnung wird nicht nur für den Abgleich der Schaltungsanordnung, sondern auch für die tatsächliche Messung eines Widerstandswertes z.B. zur Feststellung der Schleiferposition bei einem Potentiometer, der vorliegenden Temperatur oder Helligkeit usw. benutzt.

Auf einfache Art und Weise, ist bei besonders niedrigem Stromverbrauch, ein Verfahren zur exakten Bestimmung von Widerstandswerten R_{MESS} und/oder Kapazitätswerten realisiert, zu dessen Anwendung vorteilhafter Weise besonders wenig Speicherplatz benötigt wird.

## Patentansprüche

1. Verfahren zur Bestimmung von Widerstands- und/oder Kapazitätswerten mittels eines auf einem Chip vorhandenen Mikrocontroller mit zugeordnetem Oszillator bei dem zunächst eine mindestens einmalige Referenzmessung vorgenommen wird, bei der eine Referenzkapazität (C_{Ref}) über einen Referenzwiderstand (R_{Ref}) auf einen definierten Spannungspegel geladen bzw. entladen wird und die dazu benötigte Zeit durch Zählen der Oszillatorperioden bestimmt wird, **dadurch gekennzeichnet, dass** die zur Messung der Zeit benutzte Frequenz des Oszillators (VCO) solange verändert wird, bis der Messwert (N_{Mess}) einen im Mikrocontroller gespeicherten Sollwert (N_{Ref}) erreicht hat und anschließend die sich aus der Referenzmessung ergebende Frequenz des Oszillators (VCO) für die Bestimmung eines aktuell vorliegenden Widerstandswertes (R_{Mess}) und/oder Kapazitätswertes (C_{Mess}) vom Mikrocontroller herangezogen wird.

2. Verfahren zur Bestimmung von Widerstands- und/oder Kapazitätswerten nach Anspruch 1, **dadurch gekennzeichnet, dass** zur Einstellung der variablen Frequenz ein spannungsgesteuerter Oszillator (VCO) herangezogen wird.

3. Verfahren zur Bestimmung von Widerstands- und/oder Kapazitätswerten nach Anspruch 1, **dadurch gekennzeichnet, dass** zur Einstellung der variablen Frequenz ein digital verstellbarer Oszillator (VCO) herangezogen wird.

## Claims

1. Method for determining resistance values and/or capacitance values by means of a microcontroller which is provided on a chip with an oscillator assigned to it, for which at least one single reference measurement is first conducted in the course of which a reference capacitance (C_{Ref}) is charged or discharged, as the case may be, by way of a reference resistance (R_{Ref}) to a defined voltage level and the time taken for this is determined by counting the oscillator periods, **characterised by** the fact that the frequency of the oscillator (VCO) used for measuring the time is changed until the measured value (N_{Mess}) has reached a setpoint value (N_{Ref}) filed in the microcontroller, and the frequency of the oscillator (VCO) resulting from the reference measurement is subsequently used as the basis for determining a currently existing resistance value (R_{Mess}) and/or capacitance value (C_{Mess}) from the microcontroller.

2. Method for determining resistance values and/or capacitance values in accordance with Claim 1, **characterised by** the fact that a voltage controlled oscillator (VCO) is utilised as the basis for adjusting the variable frequency.

3. Method for determining resistance values and/or capacitance values in accordance with Claim 1, **characterised by** the fact that a digitally variable oscillator is utilised as the basis for adjusting the variable frequency.

## Revendications

1. Procédé pour déterminer des valeurs de résistance et/ou des valeurs de capacité au moyen d'un microcontrôleur existant sur une puce avec un oscillateur affecté, pour lequel il est pris tout d'abord une mesure de référence au moins unique pour laquelle une capacité de référence (C_{Ref}) est chargée resp. déchargée via une résistance de référence (R_{Ref}) sur un niveau de tension défini et le temps nécessaire à cet effet est défini par comptage des périodes d'oscillateur, **caractérisé en ce que** la fréquence de l'oscillateur (VCO) utilisée pour la mesure est modifiée jusqu'à ce que la valeur de mesure (N_{Mess}) ait atteint une valeur de consigne (N_{Ref}) mémorisée dans le microcontrôleur et ensuite la fréquence de l'oscillateur (VCO) résultant de la mesure de référence soit consultée du microcontrôleur pour la détermination d'une valeur de résistance (R_{Mess}) actuellement existante et/ou d'une valeur de capacité (C_{Mess}).

2. Procédé pour déterminer des valeurs de résistance et/ou des valeurs de capacité selon la revendication 1, **caractérisé en ce qu'**un oscillateur commandé par la tension (VCO) est utilisé pour le réglage de la fréquence variable.

3. Procédé pour déterminer des valeurs de résistance et/ou des valeurs de capacité selon la revendication 1, **caractérisé en ce qu'**un oscillateur à réglage numérique (VCO) est utilisé pour le réglage de la fréquence variable,.
